# EUROPEAN PATENT SPECIFICATION

(11) **EP 0 637 057 B1**
(45) Date of publication and mention of the grant of the patent: **11.12.1996**
(21) Application number: 93480106.9
(22) Date of filing: 30.07.1993
(51) Int. Cl.: H01L 21/00, B23K 3/06

(54) **Method and apparatus for depositing metal fine lines on a substrate**
Vorrichtung und Verfahren um feine Metal-linie auf einem Substrat abzulegen
Méthode et appareil pour déposer des lignes fine de métal sur un substrat

(43) Date of publication of application: 01.02.1995
(73) Proprietor: INTERNATIONAL BUSINESS MACHINES CORPORATION, Armonk, N.Y. 10504 (US); ORSAY PHYSICS, 91893 Orsay Cédex (FR)
(72) Inventor: Corbin, Antoine, F-75016 Paris (FR); Foulu, Jacques, F-77150 Lesigny (FR); Demoncy, Philippe, F-91100 Evry (FR); Sudraud, Pierre, F-91410 St Cyr sous Dourdan (FR)
(74) Representative: Klein, Daniel Jacques Henri

(56) References cited:
- EP-A- 0 096 433
- EP-A- 0 491 599
- DE-A- 3 612 341
- US-A- 4 606 492
- US-A- 4 862 827
- US-A- 5 159 171

## Description

The present invention relates to a method and an apparatus for depositing various materials of either the conductive or non conductive type on a great variety of substrates. It more particularly relates to a method and an apparatus for the direct writing of a desired conductive pattern of metallic conductors on an insulating substrate, based on the use of a pen which essentially consists of a refractory tip wetted with the metal in the molten state. In a specific application to VLSI semiconductor integrated circuit (IC) chips, the use of an extremely thin pointed tip results in the formation of ultra-fine lines of pure metal. The deposition process is performed at relatively high speed and produces thick lines with an excellent resolution.

Different conventional methods have been employed so far to form patterns of a conductive material on a substrate in connection with the fabrication or repair of semiconductor IC chips. As a matter of fact, it is often necessary to form patterns of a conductive material on a semiconductor structure at different times of the chip fabrication, to provide the necessary contacts, electrodes, and conductors (or lines) that are required to meet the various connection/interconnection needs. Conductive materials include doped polysilicon, low melting point metals such as aluminum (Al) or metal alloys such as aluminum-silicon (Al-Si), gold-silicon (Au-Si), and refractory metals such as tungsten (W), tantalum (Ta), and chromium (Cr). However, low melting point metals and metal alloys are by far, the most employed conductive materials in the semiconductor industry.

A typical method of forming patterns of metal is to combine lithography and a deposition techniques. E-beam evaporation or sputtering deposition and lift-off lithography are the standard techniques used to date. Typically, a thick photoresist layer is first formed onto the semiconductor structure. The resist is exposed using a photomask. This exposure step serves to trace a predetermined pattern in the resist inducing localized chemical reactions in the exposed regions. Then, the resist layer is developed in a suitable solvent, and the exposed regions (in case of a positive resist) are removed. Next, a metal layer is blanket sputtered onto the structure. Finally, the remaining portions of the resist layer are removed, leaving the desired complementary metal pattern on the structure surface.

The above described method is extensively used in the industrial production of semiconductor IC chips. However, it has some significant limitations as far as chip customization and repair are concerned. The conventional method described above is still used in the customization (or personalization) steps of CMOS gate arrays. For instance, eight of the 12 photomasks of a typical CMOS process are generic. However, there is a strong demand of customers for fast turn-around times of prototypes, small production volumes and significant engineering support in the chip design and evaluation stages, which puts an heavy pressure on gate array producers. Obviously, lithography is hardpressed to cope with the very short delays given by the customer to produce a customized chip or to repair a defective chip. As a consequence, the above described method cannot be used for instant customization of ASICs (Application Specific Integrated Circuits) or chip repair.

Likewise, different conventional methods have been employed to form patterns of an opaque material in connection with the manufacture of photomasks, but usually, using another lithographic technique.

For instance, according to a typical process of fabricating photomasks, a metal (typically chromium) coated transparent glass plate is first covered with a radiation sensitive resist layer. The resist is exposed using a well collimated E-beam, then developed as standard. The remaining patterned resist layer acts as a protective layer for the underlying metal coating. In turn, the unprotected metal is etched up to the glass plate. Finally, the remaining resist layer is removed, leaving opaque zones of metal on the glass plate surface. As known for those skilled in the art, photomasks are currently employed in the lithographic steps in the course of IC chip manufacture. As far as fabrication of photomasks is concerned, this lithographic process tends to develop two groups of defects: unwanted portions left unremoved (so-called black-spot defects) and portions needed but unintentionally etched away, (so-called clear or white-spots defects).

This method is extensively used for the industrial production of photomasks, but is clearly inapplicable to their repair. Using an additional lithographic step to repair a defective mask, by performing localized metal deposition thereon, would be pure non sense, and more often than not, a new mask is produced.

In summary, above lithographic based methods are well adapted to the mass production of semiconductor IC chips or photomasks, but not for applications such as IC chip small volume production, IC chip customization and repair, and finally mask repair. In addition, lithography has very high capital and operating costs, due to the sophisticated E-beam or photoaligner apparatus that are required to trace the pattern. As a result, alternate methods eliminating lithographic steps during prototyping and engineering have been sought to improve flexibility and save time and expense for these applications.

In that regard, two recent techniques known under the name of Focused Ion Beam (FIB) and its variant Focused Ion Beam-Chemical Vapor Deposition (FIB-CVD) obviate most of the drawbacks of above mentioned conventional lithographic processes. In particular, they are quite adapted to the ablation of metal fine lines and to the deposition of metal fine lines respectively. Consequently, they find a number of applications, in various fields of the semiconductor technology, and in particular, in the repair of IC chips and masks, but also in others related fields such as process monitoring, defect/failure analysis, device evaluation, sample preparation for microscopy and micro-analysis, and the like. In particular, the FIB-CVD is considered to date as a very promising deposition technique at the verge of a tremendous and rapid development in the semiconductor industry.

In a classical configuration adapted to metal deposition, the FIB-CVD station is housed within a column-shaped vacuum chamber that includes an X-Y stage capable of controlled movements in the X-Y directions of an horizontal plane. The column encloses a high brightness liquid metal ion source which consists of a sharp needle wetted by a film of said metal,typically gallium (Ga), in the molten state. The molten metal travels by capillary action to the needle of the ion source, where it is ionized. An extraction electrode having a difference voltage potential with the ion source extracts said beam of ions from the source. There is produced a beam of charged particles, i.e. ions, that appear to emanate from a point. A ExB mass separator can be used to select only the desired ion species and deflect the undesired species out of the beam (case where a metal alloy is used). A series of lenses is placed on the ion beam path to focus the ion beam. Next, a beam deflector is used to scan the beam over the substrate. The substrate which forms the target for the FIB is generally placed on top of an heating element affixed on the X-Y stage. A thermo-couple sensor senses the substrate temperature to provide a control to the heating element. The substrate is heated to a temperature which is high enough to support growth of the desired material. The compound which includes the material to be deposited upon the substrate is held in a gaseous state within a reservoir. A gaseous organometallic compound, e.g. tungsten carbonyl, is typically used as the working gas. A valve controls the flow of the working gas from the reservoir through a nozzle, which terminates at the very close vicinity of the substrate, and directs a flow of gas onto the desired portion thereof. A few atomic layers of the working gas are adsorbed by the substrate surface.

The focused ion beam generated by the liquid metal ion source is projected onto the substrate and scanned thereon by the beam deflector, so that the working gas is decomposed. The tungsten film is only formed in that area where the ion beam impinges the gas. The metal fine lines are formed continuously. The focused ion beam is scanned along a predetermined locus, corresponding to a desired circuit connection line (preferably in multiple scans), to grow the metal until the required thickness is obtained. This is clearly a lengthy process, and because the ion beam intensity has a value that can be increased only in a limited extent, it is quite impossible to trace relatively long lines, e.g. 1 mm, unless to suffer of an excessive loss in terms of resolution. The secondary electrons emitted from the surface of the substrate are detected by a detector, amplified and processed to be finally displayed on an appropriate display as a high resolution SIM (Scanning Ion Microscope) image. Because, a control unit drives the X-Y stage, it is possible to observe the SIM image of any desired portion of the substrate, which is a significant advantage for chip or mask repair.

The FIB-CVD station described above, is perfectly suited to perform additive processes, such as deposition of metals, but it suffices not to use said working gas to transform the station in an equipment adapted to subtractive operations such as etching (reverse sputtering), hole drilling, wire cutting, ...etc. As a result, the FIB and FIB-CVD techniques have some various and interesting applications.

For instance, although the FIB-CVD technique has limited use in the manufacture of IC chips to form electrical connections on the semiconductor structure (wherein active and passive devices have been previously formed by appropriate lithography and implantation steps), it is widely used in the repair of such chips. If there is a missing portion, i.e. an open in a metal interconnect line that was previously deposited (as a result of an original manufacturing defect), the line can be repaired by simply scanning the open area to deposit new metal and fill the open as described above.

According to the FIB-CVD technique, there is no limitation in the nature of metals to be deposited. For instance, refractory metals, including tungsten, which has the highest melting point temperature of about 3370°C, are easily deposited on an insulating or a silicon substrate, in using metal carbonyl compounds. However, the deposition of such refractory metals is more acute when GaAs is the semiconductor material, because GaAs is not easily oxidized and metallized and this disadvantage severely limits the development of this technology to date. For example, refractory metal gate electrodes are currently applied to GaAs MESFET devices by sputtering and E-beam evaporation.

In both of these processes, damage can occur to the GaAs surface. Sputtering causes impact damage and E-beam evaporation results in dissociation of GaAs. The preferred method of depositing refractory metals, is a variant of the FIB-CVD technique described just above, so-called photodeposition. As disclosed for instance in US-A-4451503 assigned to IBM, photodeposition uses ultraviolet radiation of wavelengths less than 200 nm to photodecompose the gaseous metal carbonyl compound in the vicinity of the GaAs wafer.

For the same reasons, the FIB/FIB-CVD techniques are not adapted to the manufacture of masks, to form the opaque chromium patterns on the glass plate, but they are much appreciated in mask repair applications, either to deposit new metal in white spot defects that develop in the mask pattern or to ablate undesired metal portions thereof. Again, in this instance, the SIM image is much appreciated, because it is quite interesting to determine exactly the positions of the mask defects to be repaired. Moreover, as mentioned above, it is very simple to transform the FIB-CVD station in a FIB station adapted to eliminate undesired shorts at the surface of the said IC chips by ablation.

In summary, the FIB/FIB-CVD techniques have numerous applications, including the in-situ formation of metal patterns to be used as circuit connections during the repair or customization of an IC chip, and the formation of additional opaque patterns during the repair of photomasks.

Unfortunately, in particular, the FIB-CVD pattern forming process has some significant drawbacks.

In order to obtain a good resolution, a low ion beam intensity is required, which in turn implies a ion beam having a very small diameter size, e.g. 30-40 nm. To create a 2µmxµum conductor thus requires multiple scans. The requirement of a relatively high ion dose and the fact that the ion beam must be left on the substrate during the entire deposition period, with multiple scans of the line to be deposited, significantly slow down the speed at which lines are written. The rate of line or pattern build-up to a desired thickness is finally very low.

Because it is a chemical deposition process, the resolution is naturally poor. Any attempt to raise the build-up rate mentioned above, would require to increase said ion beam intensity, causing the ion beam to go out of focus, which in turn, would result in spreading away the sputtered material in excess.

High resistivity conductors are obtained. Impurities, typically carbon and gallium atoms, are implanted during the pattern forming process. When formation of ultra-fine lines is required in VLSI IC chips, the impurity level of the deposited lines may be quite high, i.e. exceeding 25%, and thereby results in sheet resistivity much higher than desired.

As a consequence, for the reasons stated above, the FIB-CVD technique is limited to the deposition of relatively short lines, because long lines would be too resistive and would also require too much time.

Organometallic products, such as tungsten carbonyl W(CO)6, molydenum carbonyl Mo(CO)6, chromium carbonyl Cr(CO)6, and the like, that are extensively used in FIB-CVD, are dangerous and toxic compounds.

The conventional FIB-CVD station is a relatively complicated and expensive equipment and has high operating costs. It mandatorily requires to operate in a vacuum environment. Generally, the FIB-CVD station is placed in the vacuum chamber of an scanning electron microscope (SEM).

The FIB-CVD process requires relatively high dosage, on the order of 10¹⁷ ions/cm² or greater to deposit patterns or lines that are only a few hundred nanometers thick. The use of such an high dosage, can result in damages at the wafer surface.

The step of deposition requires relatively high temperatures (e.g. 300 °C) to heat the substrate, and should the substrate be a semiconductor wafer, the presence of this elevated temperature can result in detrimental phenomenon within the devices integrated there and could temporarily or even permanently alter the electrical characteristics of the said devices.

High aspect ratios are achieved with the FIB-CVD technique. A common problem attached thereto is attributable to the sharp step of conductors that are formed, while in most cases, conductors with tapered edges would have been preferred to avoid the step coverage effect with its well known related reliability problems.

Thus, although ion beams can be focused to below a micron in diameter and thus have the potential for submicron resolution, a practical way to integrate rapid and efficient metal line deposition into an IC chip manufacture and repair process has not previously been found so far. As a result, there still remains the pressing necessity of a new technique that would entail the maximum of the advantages of the FIB-CVD deposition technique (possibly introducing functions not performed by the same), while retaining only a minimum of its inconveniences. Moreover, it should be preferably adapted to provide some of the subtractive features of the FIB technique. Finally, it would be highly desirable this new technique be applicable to the fabrication of IC chips, so that a totally mask free fabrication of IC chips with no lithography steps, could be envisioned. Of course, such a new technique should be perfectly adapted to the customization and repair of IC chips and to the repair of masks as well, as presently FIB-CVD and FIB techniques do.

Therefore, it is a primary object of the present invention to provide a method and an apparatus for depositing various materials of either the conductive or non conductive type on a great variety of substrates.

It is another object of the present invention to provide a method and an apparatus for the direct writing of a desired conductive pattern on a substrate having either a regular or irregular surface.

It is another object of the present invention to provide a a method and an apparatus for depositing a metal pattern on a substrate to form electrical connections at a relatively high speed.

It is another object of the present invention to provide a a method and an apparatus for depositing a metal pattern on a substrate to form electrical connections with precise dimensions.

It is another object of the present invention to provide a method and an apparatus for depositing a metal pattern on a substrate to form electrical connections with a resistivity equal to the one of the bulk metal.

It is another object of the present invention to provide a a method and an apparatus for depositing a metal pattern on a substrate to form electrical connection lines of any desired lengths and widths.

It is another object of the present invention to provide a a method and an apparatus for depositing a metal pattern on a substrate that do not use any toxic compounds.

It is another object of the present invention to provide a a method and an apparatus for depositing a metal pattern on a substrate that requires a relatively cheap equipment of simplified construction with low operating costs.

It is another object of the present invention to provide a a method and an apparatus for depositing a metal pattern on a substrate that is capable to fill via-holes formed in said substrate.

It is still another object of the present invention to provide a method and an apparatus for depositing a metal pattern on a substrate that do not damage the surface of the substrate.

It is still another object of the present invention to provide a method and an apparatus for depositing a metal pattern on a substrate that can be normally performed at room temperature.

It is still another object of the present invention to provide a method and an apparatus for depositing a metal pattern on an insulating substrate, whose lines have tapered edges and rounded corners for improved reliability.

It is still another further object of the present invention to provide a method and an apparatus for depositing a pattern of a refractory metal on a GaAs substrate.

It is still another further object of the present invention to provide a method and an apparatus normally constructed for depositing conductive and non conductive materials on a substrate, that can be easily adapted to some subtractive processes such as scribing and electroerosion.

It is still another further object of the present invention to provide a method and an apparatus for depositing successive metal (nd insulator as well) patterns on a substrate that could lead to a totally mask-free fabrication of IC chips.

It is still another further object of the present invention to provide a a method and an apparatus for depositing a metal pattern on a substrate, that is particularly well adapted to the customization and repair of IC chips and to the repair of photomasks as well.

These objects will be accomplished by the method and apparatus of the present invention according to the subject claims.

The method and an apparatus of the present invention allows the direct writing of a desired pattern of a given material on a substrate. It is based on the use of a pen or writing head which essentially consists of a refractory tip wetted with the said material in the molten state. The tip is formed by a small piece of a wire, typically made of a refractory metal such as tungsten, that has been electrolytically sharpened and roughened. The tip is attached, e.g. by micro welding, to the top of a heater, which typically consists of a V-shaped piece of the same tungsten wire. In turn, each extremity of the V-shaped heater is welded to a pin that emerges from an insulating base support, e.g. a 3-lead TO-5 package, with three pins partially casted therein, as standard. The pen is incorporated in an apparatus adapted to the direct writing technique. To that end, the tip is attached to a supporting device, which is preferably operable to move along the Z-axis, while the substrate is placed on an X-Y stage, for adequate X, Y, and Z relative movements therebetween. The two pins of the pen are connected to a power supply to resistively heat the heater. When the welding point of the tip/heater assembly reaches the melting point temperature of the material to be deposited, it is dipped in a crucible containing the said material in the molten state. The welding point nucleates a minute drop of the liquid material and thus forms a spatial reservoir without any container. A thin film of the liquid material flows from the reservoir and wets the whole tip surface. Finally, the wetted tip is gently brought into contact with the substrate and deposition of the material takes place. A physical contact between the tip apex and the substrate surface is not required, which limits tip wear. Preferably, the tip/heater assembly is vibrated to facilitate deposition of the material. Different configurations of tips may be used to create different types of patterns. For instance, ultra-fine lines of metal can be formed to define the electrical connections of an IC chip, or larger zones of an opaque material in the repair of masks, as well.

In essence, the deposition method of the present invention, consists in the direct writing of a material on a solid substrate using a tip wetted with the said material in the molten state. Various materials, either of the conductive type including standard metals (Al) and metal alloys (Al-Si, Au-Si, ...) and some refractory metals (Cr, Ta, ...) or of the non-conductive type, such as organic or non-organic insulators, can be deposited. The substrate may be selected in a great variety of supports and may have either a planar or non-planar surface. Moreover, with the method and apparatus of the present invention, a totally mask free manufacture of semiconductor IC chips, and in particular of III-V IC chips, is henceforth possible. The deposition method of the present invention has numerous advantages and applications not only in the semiconductor technology field but in other fields as well.

The features believed to be characteristic of this invention are set forth in the claims. The invention itself, however, as well as other objects and advantages thereof will be best understood by reference to the following detailed description of an illustrated preferred embodiment to be read in conjunction with the accompanying drawings.

Fig. 1 is a schematic diagram of the pen according to the teachings of the present invention.

Fig. 2A is a schematic diagram showing an enlarged view of the tip/heater assembly of the pen of Fig. 1.

Fig. 2B is a schematic diagram showing the tip/heater assembly of Fig. 2A when wetted with a liquid material.

Fig. 3 illustrates a schematic diagram of the apparatus of the present invention.

Fig. 4 is a schematic diagram showing the pen/piezo device assembly of the apparatus of Fig. 3.

Fig. 5 is a photograph showing a perspective view of the experimental set-up of the apparatus of Fig. 3.

Fig. 6 is a schematic diagram to illustrate the direct writing method of the present invention when applied to the formation of a fine line of a given material onto a substrate.

Fig. 7 is a photograph that illustrates the direct writing method of the present invention when applied to the formation of a metal connecting strap or land onto a polyimide sheet.

Fig. 8 is a photograph showing an enlarged cross-sectional view of the metal connecting land of Fig. 7, to illustrate the typical tapered edges and rounded corners thereof.

Fig. 9 is a plot of the resistance (in Ohms) of the metal connecting land of Fig. 7, as a function of its length/surface ratio (in µm ⁻¹).

Fig. 10 is a photograph showing a pattern of parallel metal conductive lines formed onto an SiO2 insulating substrate still according to the method of the present invention.

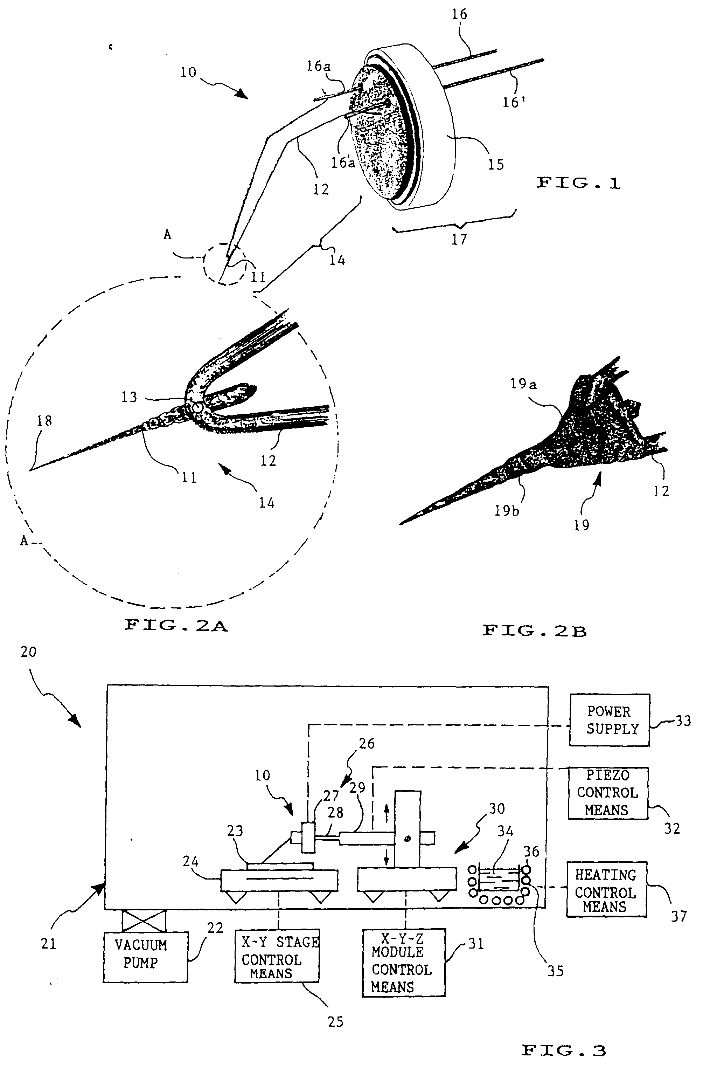

As illustrated by Fig. 1, the pen 10 basically consists of a tip 11 formed by a small pointed piece of a refractory metal, such as tungsten, that has been sharpened and roughened (for better wetting with the material to be deposited) according to an electrolytic process to be described below in more details. In a preferred embodiment, the tungsten tip 11 is attached, for instance by welding, to the top extremity of a V-shaped piece of a tungsten wire, referred to thereafter as the heater 12. The welding point and the tip/heater assembly are respectively referenced 13 and 14 in Fig. 1. Still in this preferred embodiment, a standard 3-lead TO-5 package base 15 including two pins 16 and 16' is used to be the holding device for the tip/heater assembly 14. The two other extremities of the V-shaped heater 12 are welded to the extremities 16a and 16'a of respective pins 16 and 16 that emerge at about 3mm of the base 15 surface. The free extremities of the pins are ready for being connected to a power supply to resistively heat the tip/heater assembly, when the pen is mounted in the apparatus, as it will be explained later on. This terminates the description of the pen or writing head 10.

An adequate process of fabricating the heater/tip assembly 14, which is the key element of the pen 10, reads as follows. In a preferred embodiment, the starting material to fabricate the tip 11 and heater 12, is a 0,1mm diameter tungsten wire, such as supplied from MOLYTECH, Meribel, France. However, the tip and the heater can be fabricated using other materials, the tip/heater assembly must be fabricated with a material whose melting temperature is higher than the melting temperature of the material to be deposited and which is capable to be wetted therewith. In addition, no chemical incompatibility should exist between the material forming the tip and the material to be deposited. First of all, the V-shaped heater 12 is formed by folding a small piece of said wire. Typically, each side or leg of the V-shaped wire forming heater 12 is about 1,5 cm long. As apparent from Fig. 1, the top of the V is slightly tilted with respect to the legs, to form an angle of about 45° therewith, approximately at two-third from the top. Then, a 2mm long piece of the same tungsten wire, that has been previously coarsely cut with cutting pliers, is welded at the top of the V, at welding point 13, to form the tip 11. In turn, the extremities of the heater 12, opposite to said top, are welded to pin extremities 16a and 16'a. Now, an electrolytic process is performed to sharpen the tip on about half of its length and to roughen the whole tip and the top portion of the heater at the close vicinity of welding point 13 (a few millimeters of the tilted portion). The tip is roughened for a better wetting by the material in the molten state. However, certain materials such as Au-Si alloys wet the tip without this requirement. Likewise, the said top portion of the heater is also roughened to facilitate the formation of a bullet of molten material as it will be described in more details later on. For instance, this sharpening and roughening may be obtained according to the processing steps now described. The tip is dipped in an electrolytic bath comprised of an NaOH and glycerol solution (8g NaOH/100ml glycerol) kept at about 40°C, so that its coarsely cut extremity is eliminated by applying a 20V AC voltage between the electrode and the tip, as standard. Next, the remaining tip (about 1mm) is dipped again in the same solution, but now a variable voltage decreasing from about 15 to about 5V, is applied during about 90s to sharpen the tip and obtain the desired shape and apex radius. Finally, the tip and said heater top portion are etched to provide the desired rugosity at their surface. To that end, they are dipped in the solution with a low tension, e.g. 1V and during a few seconds e.g. 1 to 3s, to create the necessary pitfalls. The resulting structure is illustrated in Fig. 2A, which shows an enlarged view of the tip/heater assembly 14 of Fig. 1, and clearly evidences the typical needle-shaped profile of the tip and the roughened surface of the tip and heater top portion. As to this described electrolytic process, technical background can be found in the article authored by JP Ibe et al, Journal of Vacuum Science and Technology A, 4, 3570 (1990)). In Fig. 2A, where the tip apex is referenced 18, the tip apex radius is about 1µm. In a typical application to the forming of ultra-fine lines of metal for VLSI IC chips, a tip apex radius of approximately 0,5 to 2 µm is generally adequate. In reality, the apex radius is not a critical parameter of the tip, because, as it will be explained later on, there is no need of a physical contact between the tip 11 and the substrate.

A method of wetting the tip with the material in the molten state is now given hereinbelow. First, the heater/tip assembly 14 (at the vicinity of the welding point 13) is heated until it reaches the melting point temperature of the material to be deposited. Then, the assembly is dipped in a crucible containing the said material in the molten state. Because of surface tension forces, the welding point 13 nucleates a minute drop or bullet of the liquid material that forms "spatial" reservoir 19a. From reservoir 19a, the liquid material flows and in turn forms a film 19b that wets the whole tip 11 surface. In reality, the reservoir and the film form a continuous volume of liquid material, whose contour is visible, under reference 19, in Fig. 2B. It is noticeable to remark that the reservoir 19a does not require any container to store the material.

There is no apparent physical limits in the tip diameter. In particular, the tips of the present invention can be employed in fields such as the semiconductor and packaging technology. Other technical fields may be envisioned as well. For instance, tip diameters in the range of 0,5 to 2µm can be used to fabricate or to modify the conductors of the standard devices that are integrated to date in VLSI semiconductor IC chips. Even smaller tip diameters, in the range of 10-100 nm, can be used to fabricate more integrated devices or quantum devices. Conversely, the extension towards tips of larger sizes (e.g. 10-1000 µm) is readily feasible. Such larger tips can find applications in the manufacture of metallized ceramic (MC) and multi-layer ceramic (MLC) substrates. A needle-shaped tip has been described in this preferred embodiment, by reference to Figs. 2A and 2B, however, this particular design must not be interpreted limitatively. Other pointed tip shapes may be envisioned as well such as post-shaped, doctor blades, brush-like tip structures, and the like. As a matter of fact, the nature of the refractory material forming the tip, its length, shape, and other parameters as well, depend upon the specific application involved. Moreover, different designs or variants of the tip/heater assembly 14 may be contemplated. For instance, instead of being V-shaped, the heater may be shaped into a coil (which will significantly increase the reservoir capacity). Likewise, the tip may be inserted at the interior of a thin capillary tube connected to a source of liquid material (for automatic feeding of the tip), ... etc. The apparatus which incorporates the pen 10 of the present invention, is schematically depicted in Fig. 3 where it bears numeral 20. According to a preferred embodiment, apparatus 20 comprises a vacuum chamber 21 connected to a vacuum pump 22. The substrate 23 is carried by an X-Y stage or table 24 whose movements are controlled by conventional control means 25. The holding device 17 of pen 10 is attached to a supporting frame 26, which, in the described preferred embodiment, first includes an annular plastic part 27 adapted to receive the base 15 of pen 10 on one face. The two free extremities of pins 16 and 16' of pen 10 are emerging on the opposite face. The latter is provided with a central recess adapted to receive the first extremity of an arm 28 forcedly engaged therein. The other extremity of arm 28 is affixed to the strip of a piezo device 29 by a screw. Finally, the piezo device 29 is mounted on module block 30 to terminate construction of supporting frame 26. For instance, appropriate piezo devices are available from Tokin Corp, Tokyo, Japan under reference NLA 2x3x18. The module block 30 can actuate the pen 10 in the X, Y and Z directions thanks to three stepping motors (optionally module block may also rotate the pen), under the control of control means 31. The Z direction stepping motor allows coarse adjustment of the spacing distance or gap between the wetted tip and the substrate, just to come within the effective range (about 1 mm) of the piezo device. The role of the piezo device 29 is then to finish the fine adjustment of the said spacing distance, when the wetted tip is brought into contact with the substrate. In addition, it is operable to cause vibrations to the tip along the Z direction. The piezo device 29 is driven under the control of piezo control means 32. These vibratory movements may reveal to be mandatory in certain situations, e.g. to overcome surface irregularities (such as micro-stairs), or to fill via-holes or even to initiate the deposition process. On planar substrate surfaces, these vibratory movements are generally no longer required but in all cases, they facilitate the deposition process. X-Y stage 24 and module block 30 are standard parts and are commercially available, for instance, from RAITH GMBH, Dortmund, Germany. The two pins 16 and 16' of pen 10 are connected to power supply 33 for resistively heating the tip/heater assembly 14. The man skilled in the art easily understands that the X, Y, and Z relative pen/substrate movements, which are required for the direct writing operation, can be achieved in a number of manners. The material 34 in the molten state is contained in a crucible referenced 35, provided with an heating coil 36 and associated temperature control means 37 as also illustrated in Fig. 3. The crucible is designed so that the pen may be dipped therein to feed (or refeed) the reservoir 19a or just to decontaminate the tip. There is no apparent need to implement an automatic feeding system, because of the capacity of the reservoir and the extremely small quantity of material that is required to the deposition process. As a matter of fact, the capacity of the reservoir 19a shown in Fig. 2B is about 1 mm3, assuming the material to be deposited is a metal, this capacity would allow to write about 1 km of a 1µm x 1µm conductive line. Alternatively, the pen may be supplied to the user with the reservoir pre-filled, so that the pen is ready at once, it just suffices to heat the reservoir to have the tip wetted in a few seconds. However, should such an automatic feeding system be required, there would be no obstacle in any respect.

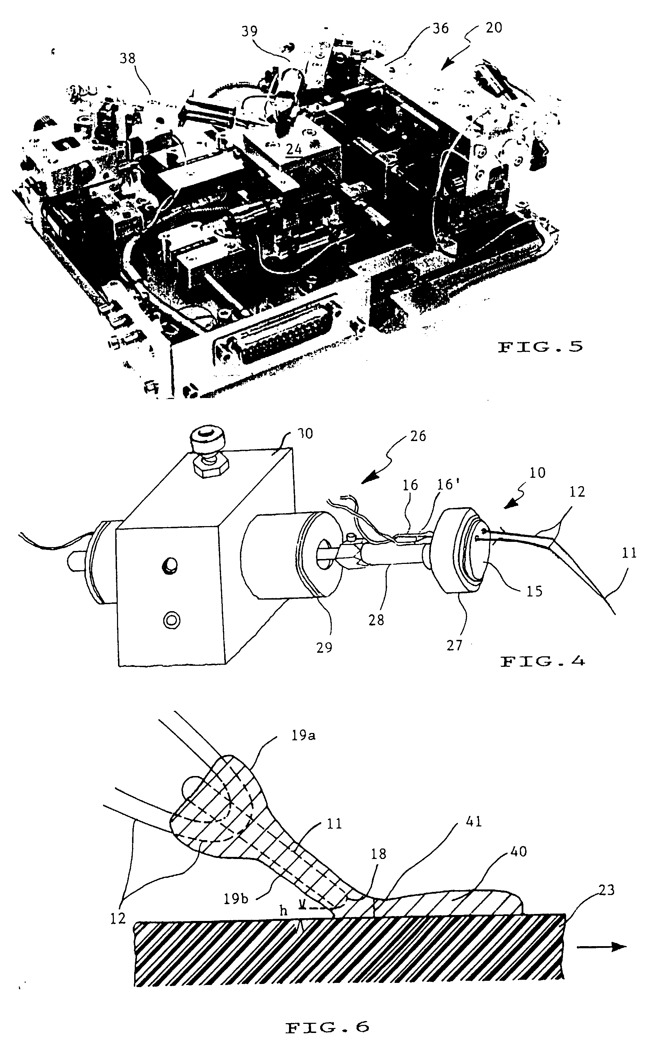

Fig. 4 is a partial enlarged view of the pen/supporting frame assembly of Fig. 3. As apparent from Fig. 4, the tip 11 is disposed substantially obliquely, at about 45° with respect to an horizontal plane. The two free extremities of pins 16 and 16' are emerging through the said opposite face of part 27 and are connected via wires to power supply 33. Likewise, the piezo device 29 is also electrically connected to piezo control means 32 via a single electrical wire as standard.

The fine tip apex-to-substrate spacing distance adjustment can be controlled in a great variety of manners. Manual adjustment can be performed by optical observation either directly or through a binocular or a microscope. It can also be performed automatically based on the use of sensors sensitive to repulsive or attractive atomic/capillary force effects, pressure, capacitance or line resistance measurements, and the like. Still assuming the material to be deposited is a metal, apparatus 20 may preferably further include an electrical continuity probing system. Two test probes are useful to perform electrical continuity or resistance measurements. In this instance, a master-slave system can be adapted to apparatus 20, so that, if the probing system detects any discontinuity (caused by a "skip" of the tip) during formation of a conductive line, the pen may resume the deposition process. The adaptation of a temperature controller, for a more accurate control of the tip/heater assembly 14 temperature, for instance by IR micro-pyrometry, is also within the purview of the man skilled in the art.

According to the embodiment of Fig. 3, the tip/heater assembly 14, once connected to the power supply 33, maintains the material in a molten state, so that the liquid material continuously flows from the reservoir 19a and wets the tip surface with film 19b. However, other direct and indirect heating techniques of the reservoir 19a, such electron and laser bombardment, induction, and the like are encompassed as well. No heating device is provided to heat the substrate 23, however, such a device could be easily adapted if so required. Obviously, because of its simplified construction, the apparatus 20 of Fig. 3 could be fully automated.

Finally, it is also to be noted, that the present apparatus is fully compatible with existing FIB-CVD stations. In this case, if the apparatus is housed in the vacuum chamber of a scanning electron microscope or of a FIB station, the SIM image, whose usefulness was mentioned above as to an accurate control of the writing process, is fully available. The apparatus 20 of Fig. 3 normally operate at the room temperature. Moreover, it may also operate at the ambient atmosphere, if the tip refractory material is not destroyed in air when it is heated. However, in certain cases, e.g. deposition of Au-Si, this difficulty can be overcome if a neutral gas (nitrogen or argon) is blown, so that oxidation of the tip/heater assembly 14 is avoided (and contamination of the deposited Au-Si metal as well).

Fig. 5 is a photograph showing the experimental set-up of the apparatus 20 of the present invention that has been reduced to practice. The probing system mentioned above includes two probers 38 and 39 mounted on their respective module blocks.

The principle of the deposition method will be now described. A typical simple way of feeding the welding point 13 with said liquid material reads as follows. First of all, it is necessary to create a source of material in the molten state. For instance, in the vacuum chamber 20 (see Fig. 3), crucible 35 is filled with an ingot or pellets of the material to be deposited. The material 34 is heated to above its melting point temperature. Simultaneously, the pen 10 pins 16 and 16' (Fig. 1) are connected to power supply 33, so that an adequate current passes therethrough for resistively heating the tip/heater assembly 14. The temperature of the tip/heater assembly at the vicinity of the welding point 13, is raised to above the said melting point temperature of the material. The purpose is to prevent any thermal shock therebetween. Next, the tip/heater assembly is dipped in the crucible, reservoir 19a is filled and film 19b is created. As soon as the tip 11 is wetted by the film, it is ready for use. In case the pen was previously used (pre-filled reservoir), the remaining material forming the reservoir and the film being solidified, it just suffices to heat the tip/heater assembly as explained above, to achieve the same result. The wetted tip 11 carried by supporting frame 26, being in the "up" position, is moved along X and/or Y directions, to be positioned just above the initial deposition point. Supporting frame is moved via control means 31 either manually with a micromanipulator or automatically. Then, the tip is coarsely adjusted above the substrate, e.g. at approximately 1mm, in the Z direction using the Z stepping motor. Next, a fine adjustment is performed with the piezo device (still in the Z direction) by visual inspection until the film of liquid material coating the tip comes in intimate contact with the substrate surface. This fine Z movement is completed under control of piezo control means 32 (Fig. 3). For the rest of the deposition process, it is convenient (essentially to avoid defocusing of the SIM image, if any), to move the substrate only by actuating the X-Y stage under the control of control means 31. The man skilled in the art will understand that, what is sought in reality, are appropriate X, Y, and Z relative movements between the tip and the substrate.

Now turning to Fig. 6, the liquid material flows (on the action of capillary forces) from the film 19b wetting the tip 11 onto the surface of substrate 23 and becomes solid thereon, for instance writing a fine line 40 of the said material as soon as substrate 23 is moved in X and/or Y directions. A typical location of the liquid/solid interface front is referenced 41. Relatively high accuracy movements between tip and substrate (mechanical/piezo) allow to place the wetted apex of the tip at the appropriate spacing distance h to have deposition to take place. In essence, the liquid material flows from the tip, wets the substrate surface and is solidified thereupon. The method described in conjunction with Fig. 6 finds direct application in the formation of ultra-fine conductive lines to meet the interconnection requirements of VLSI IC chips. However, the present method is capable of forming many other patterns, and in particular is capable to create metal test pads (e.g. either by multiple scanning if the described pointed tip is used or by employing a doctor-blade tip), that are so much appreciated in device test and evaluation. It is to be noted, that unexpectedly, the method of the present invention is capable of fabricating dendritic like structures and bridge-shaped conductors.

As soon as the substrate is moved, line 40 is formed with an excellent adherence therewith. Note that, as apparent from Fig. 6, it is not necessary to have the tip 11 apex brought into physical contact with the substrate surface, according to a significant feature of the present invention. As a result, tip apex wear is significantly limited and a long usage of the tip is expected.

As mentioned above, according to another significant feature of the present invention, a vibratory movement can be applied to the tip to facilitate deposition at the initial point and can be maintained during all the deposition process if so desired. In some instances, the substrate may act as a heat-sink and thus cools the liquid material at the tip apex. This is particularly true when a metallic substrate is used (for instance, when a conductive land must contact a metallic pad, as illustrated in EXAMPLE 1 below). In this instance, the interface front 41 of Fig. 6 tends to move towards the tip apex, making thereby the deposition process more difficult. The role of the vibratory movement is thus to prevent solidification of the liquid material at the contacting point. The very high accuracy of the combined X-Y movements of stage 24 with the Z movement provided by the piezo device 29 allow to deposit the material without any damage for the substrate 23. It is further possible, with the vibratory movement of tip 11 to overcome a "micro-stair" or even to fill a via-hole. As a result, still assuming the deposition of a metal, it is then possible to make conductive lines and studs in the Z direction, opening thereby the feasibility of fabricating 3-D structures.

In addition, still according to another significant feature of the present invention, when a metal is deposited on a metallic substrate, in the instance mentioned above, a current generator may be connected between the tip/heater assembly and the metallic pad (must be grounded), to significantly improve the deposition process. The DC current which is superposed to the DC heating current supplied by power supply 33 produces micro-discharges which in turn, cause the formation of small metal dots that have an astonishing adherence. These dots can be overlapped to create a conductor. As a result, the pen of the present invention is readily adaptable to the micro-arc welding technique.

Finally, the deposition process is usually achieved at room temperature. The deposition rate should be tuned to yield continuous deposition. In general, speeds in the range of 20 µm/s are appropriate, but they obviously depend of the substrate surface quality and specific application involved.

According to the present invention, the principle of deposition can thus be compared to the microscopic reproduction of writing on a plate with a ink pen, wherein the pen would consist of a sharpened and roughened refractory metal tip, and ink be replaced by a material in the molten state.

### EXAMPLE 1

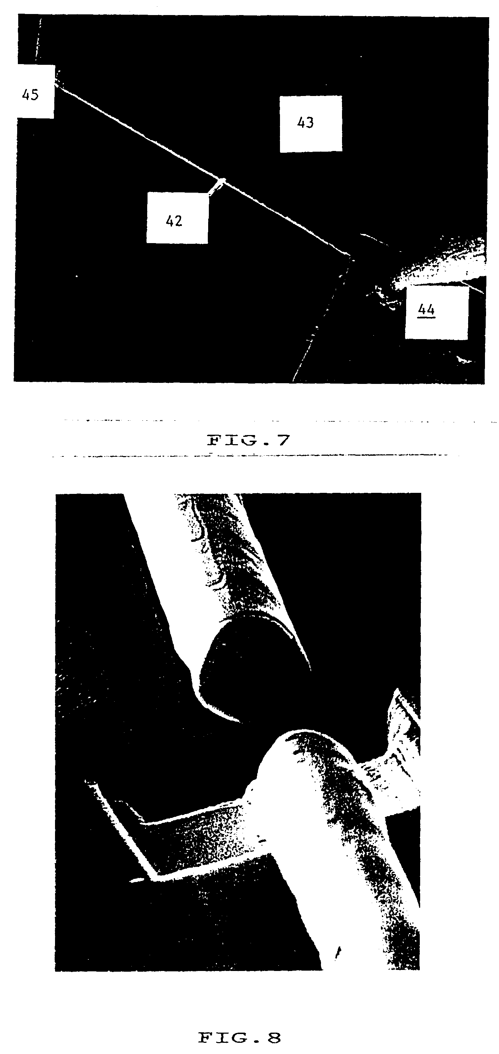

Au-Si metal alloy fine lines are deposited to form a conductive strap or land 42 on the surface of a substrate, in this instance, a polyimide sheet 43 having two square-shaped gold pads 44 and 45, as depicted in Fig. 7. Operating parameters are: a heating DC current of about 0,7A flowing in the heater 12 to raise its temperature to just above the Au-Si melting point temperature, i.e. about 350°C. As soon as the film 19b is formed, the wetted tip 11 is gently brought into contact with pad 44 (the tip apex to pad surface spacing distance is about a few nanometers). The tip is vibrated in the Z direction to ensure a good adherence of the Au-Si metal alloy on the gold pad. Next, the polyimide sheet 43 begins adequate movements in the X and/or Y direction. As apparent from Fig. 7, the obstacle formed by the "micro-stair" at the pad 44 sidewall is properly overcome with no electrical discontinuity between the two pads. The speed, frequency and magnitude of the vibration are adjusted according to the interaction between the deposited Au-Si and the polyimide sheet. In the instant case, the speed deposition is about 5µm/s, the vibration amplitude is 0,5µm and frequency is about 20Hz. The land 42 that is obtained has a cross-section of about 3 µm x 3 µm. Once the "micro-stair" is overcome, the deposition continues onto the polyimide sheet 41, and the vibration of the tip is no longer a mandatory requirement. The deposition method described by reference to EXAMPLE 1 demonstrates that the direct writing method of the present invention is not limited to substrates having planar surface, but is still operative with irregular surfaces, as well.

As apparent from Fig. 8, which shows a cross-sectional view of land 42 of Fig. 7, whose edges or sidewalls are tapered and the corners thereof rounded. The method of the present invention may be thus used to improve the topology of metal lines or conductors and is particularly attractive when applied to refractory metallization in that respect. Moreover, the land section and the neat aspect of the Au-Si alloy/polyimide sheet interface are good indicators of the excellent adherence of the land forming metal with the polyimide sheet.

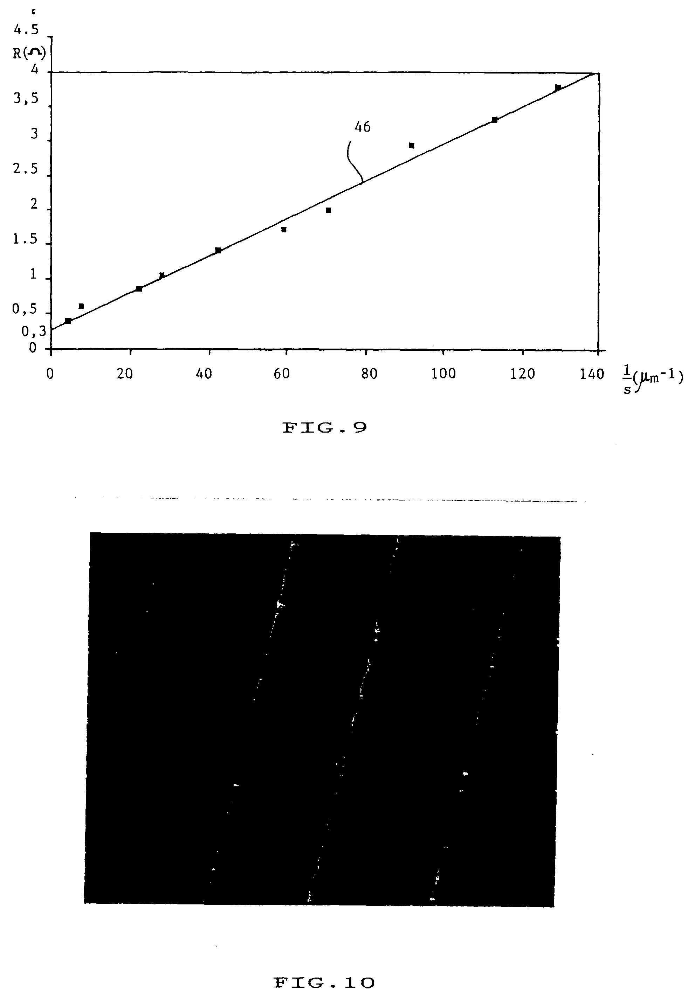

Now turning again to Fig. 7, between pads 44 and 45 that are spaced of about 180 µm, the measured resistance is 0,2 Ohms. Fig. 9 is a plot of the measured resistance R (in Ohms) versus the land length, more exactly the land length/land section ratio, i.e. l/s (in µm⁻¹). Curve 46 which averages the different measured points has a slope which is illustrative of the resistivity of the deposited Au-Si. It is thus clearly apparent from Fig. 9, that the the resistivity of the deposited Au-Si is substantially identical to the one of the bulk Au-Si metal alloy (2,6 10⁻⁶ Ohms-cm).

### EXAMPLE 2

Fig. 10 is a photograph that illustrates a pattern of fine parallel Au-Si lines that were obtained on an SiO2 substrate according to the method of the present invention. The speed deposition was 10 µm/s. The lines are spaced of about 40 µm and have a cross-section of about 5 µm wide and 2 µm high.

Therefore, various conductive materials including standard metals and metal alloys (Al-Si, Au-Si, Cu, ...) and refractory metals (Ta, Ti,..) can be deposited, except of course, tungsten (W) which forms the tip/heater assembly. However, non-conductive materials such as non-organic insulators (Si₃N₄, SiO₂, ...) or organic insulators (polymers) can be deposited as well when they have appropriate wetting and viscosity/fluidity characteristics. Deposition of other materials exotic to the semiconductor technology field is also possible. These materials include molten salts, resists, solutions, biological molecules and structures, ...etc. Depending on the material to be deposited, it may be required either to heat or to cool the substrate. Moreover, the substrate may be any type of material but not restricted to: ceramics, quartz, glasses, semiconductors such as Si and GaAs, insulating coatings such as nitrides and oxides, polymers such as polyimides, metals, ...etc.

Because of its specific pointed shape, the tip 11 of the present invention may also be used for subtractive processes. Many applications require fine lines formed onto a substrate to be delineated by ablation.

A first conventional technique is mechanical scribing. Exemplary of articles typically produced by mechanical scribing are reticle masks. A resistless process is thus sought in contrast with relatively expensive fine line lithographic techniques developed for IC chip fabrication. In that respect, mechanical scribing technique has far lower capital and operating costs, but some doubts remain on its capacity of scribing the ultra fine lines (e.g. 0,35 µm) that will be required in the near future to fabricate the photomasks for advanced IC chips. Tip 11 of the present invention is capable of any use as far as standard mechanical scribing is concerned, but tip 11 is much more efficient, because the piezo device 29 provides additional destructive capabilities (power-hammer effect) that cannot be attained with standard tips.

The mechanical scribing technique described above, uses a pointed piece of a solid material, in this instance the tip 11, to shape a workpiece. Conductive materials can also be shaped by electromachining processes such as electric discharge machining (EDM), and in particular by the electro erosion machining. In this case, the workpiece is grounded and an arc is struck between an electrode and the workpiece. If the workpiece is sufficiently good conductor, the arc forms a plasma which vaporizes the material of the workpiece, at the vicinity of the arc. A reasonable control of the material removal is possible through arc control. A technique of drilling micro holes in various workpieces, such as reticle masks, is described in US-A-5149404 assigned to ATT.

Tip 11 of the present invention can be readily adapted to operate this way. In a typical application, the tip 11, which plays the role of an electrode, is held in close proximity to, or contacting the workpiece to be scribed. The pins 16 and 16' are shorted and connected to one terminal of an electric power supply, the workpiece being connected to the other, via a switch. The tip is placed in contact or near contact with the workpiece by either gravity or other force such as provided by a system of spring. The contact force, if so required, depends on the specific application. When the power supply is switched on, the tip and the workpiece are translated with respect to each other, and the scribing takes place. The pen of the present invention may thus find another range of applications, for instance, in the fabrication or the repair of photomasks.

Therefore, the method and apparatus of the present invention exhibit many advantages. The method is adequate for the deposition of various materials on a great variety of substrates. Conductive materials, such as metals, non conductive materials, such as insulators, and other materials, such as semiconductors or superconductors, can be deposited. Refractory metals can be deposited, except tungsten, which is the preferred material forming the tip/heater assembly. The substrate surface needs not to be planar.
- The tip is prevented from premature wear, because no physical contact with the substrate is required. As an additional result, the present method does not harm the substrate surface, unlike the standard FIB-CVD deposition technique, which requires high ion dosage.
- The piezo device may reveal to be a determining feature in certain cases, for instance, to initiate the deposition process and to fill via-holes. Moreover, the piezo device may be combined with a current generator to produce micro discharges for improved adherence of the deposited metal on a metallic substrate.
- The deposition process is of the direct type. A metal connection line (e.g. 2 µm x 1 µm section) can be deposited at a speed of some tens of µm/s. In addition, the resistivity of the deposited metal is equal to the resistivity of the bulk metal to be deposited. As a result, it is easy to establish relatively long conductive lines to form the conductors of IC chips, e.g. several hundred of microns. Moreover, said lines have the desired tapered edges.
- The deposition process is very accurate. For instance, the high resolution of the method of the present invention allows to fill an open between two ultra-fine conductive lines with minimal spacing, for instance, two 0,3 µm wide lines spaced of about 0,3 µm.
- The deposition of metals is achieved without any toxic gas or compound, usually at room temperature and at the ambient atmosphere.
- A number of different tip shapes and sizes may be used to produce a great variety of patterns.
- The apparatus of the present invention is of simple construction and has low operating costs compared with the FIB-CVD stations.
- It is easily adaptable to some subtractive processes, such as mechanical scribing and electroerosion machining.

As a consequence, the method and apparatus of the present invention finds a wide range of applications.

First of all, the capacity of forming highly conductive fine lines of metals, is a much appreciated feature for the customization and repair of IC chips. However, resistors, instead of highly conductive lines could be deposited as well, should appropriate compositions be used, such as cermets. On the other hand, the capacity of forming large zones of an opaque material is very useful in the fabrication and repair of photomasks.

The capacity of filling via-holes (stud forming process), to deposit metal on the side of devices, and to deposit insulator on limited zones of a device, is a determining factor in the fabrication of 3D structures.

The capacity of depositing insulators may also be used to form small isolation regions and connections for optical fibers for instance, if molten glass is used as the deposited material.

Other concerned fields include: fabrication of hybrid circuits, diffraction gratings, solar cells, quantum devices and the like.

In particular, the method and apparatus of the present invention appear to be perfectly adapted to the fabrication of solar cells. Multiple adjacent pens may be easily combined with a ribbon of silicon transported by a continuously moving belt for inexpensive mass production of the same.

This method appears to be extremely important for failure analysis (pad forming process), sample preparation, micro-analysis, reconfiguration of IC chips and the like.

Moreover, the IC chip and mask repair can be integrated into quality control cycles in which any defects in the patterns originally deposited are corrected as soon as the manufacture of the IC chip or mask has been completed. Therefore, it could be worthwhile to have the apparatus of the present invention at key locations of the manufacturing line.

Another unique benefit of the method and apparatus of the present invention is its compatibility with other FIB techniques, such as ion implantation and ion milling or reverse sputtering, so that the integration of the metal deposition technique of the present invention would make possible an integrated, completely mask-free IC chip fabrication system.

## Claims

1. An apparatus (20) for the direct writing of a desired pattern of a given material onto a substrate (23) having a major surface comprising:
substrate support means (24) for supporting said substrate;
a solid cone-shaped tip (11) made of a refractory material whose melting temperature is superior to the melting temperature of the material to be deposited, the external surface of said tip being capable to be wetted by said material in the molten state;
tip supporting means (12,15,26) adapted for maintaining the tip apex (18) above the said major surface of the substrate and at a determined spacing distance (h) therefrom while moving along directions parallel to the substrate
supply means (19a) for feeding the external surface of the tip including its apex with a film (19b) of said material in the molten state by capillary forces;
heating means (12) for maintaining the said film slightly above the melting temperature of said material; and,
controlled drive means (25,31) for producing relative movements between said substrate and the tip.

2. The apparatus of claim 1 wherein said heating means are selected in the group including : electron bom bardment, laser bombardment, induction heating and resistive heating.

3. The apparatus of claim 2 wherein said heating means is resistive heating means.

4. The apparatus of claim 3 wherein said tip supporting means includes a tip holding means (17).

5. The apparatus of claim 4 wherein said tip holding means essentially consists of a TO-5 package base (15) provided with two pins (16,16').

6. The apparatus of any above claim wherein the material forming said tip is a refractory metal.

7. The apparatus of claim 6 wherein the refractory metal is tungsten.

8. The apparatus of claim 7 wherein said resistive heat ing means consists of a heater (12) made of a V- shaped wire of tungsten whose top is welded to the extremity of said tip opposite to the apex at a weld ing point (13) and whose two others extremities are welded to the extremities (16a,16'a) of said pins (16,16') embedded in said base for connection to a controlled power supply (33).

9. The apparatus of claim 7 wherein said resistive heat ing means consists of a heater made of a coil of a tungsten wire whose two extremities are welded to the extremities (16a,16'a) of the said pins (16,16') and wherein the extremity of the tip which is opposite to the apex is welded to a winding of the said coil, so that the welding point (13) is located at approxi mately in the middle of said coil.

10. The apparatus of claim 8 or 9 wherein the tip andthe heater surface at the vicinity of the said welding point has the capability to nucleate a certain amount of the when dipped in the material in the molten state, said amount, in turn, forms a reservoir (19a) of the same that wets the tip, when the latter is heated at the material melting point temperature.

11. The apparatus of any above claim 10 wherein said external surface is roughened.

12. The apparatus of any above claim wherein said tip supporting means (26) is adapted to provide fine movements to the tip in the Z direction.

13. The apparatus of claim 12 wherein said tip supporting means further includes a piezo device (29) affixed on a module block (30) and having an arm (28) attached to said holding means (17).

14. The apparatus of claim 13 wherein said piezo device is adapted to provide fine movement of the tip in the Z direction.

15. The apparatus of claim 13 or 14 wherein said piezo device is adapted to provide vibrations to the tip.

16. The apparatus of any above claim wherein said tip supporting means further includes means to provide coarse movement in the Z direction to the tip.

17. The apparatus of claim 16 wherein said means to provide coarse movement includes a stepping motor in the module block.

18. The apparatus of any above claim further including a vacuum chamber means (21) connected to a vacuum pump (22) for enclosing said apparatus in a clean atmo sphere.

19. The apparatus of any above claim further including crucible means (35) for containing said material (34) in the molten state.

20. The apparatus of claim 19 wherein said crucible means are enclosed within said vacuum chamber.

21. The apparatus of any above claim wherein said sub strate support means comprises an X-Y stage.

22. The apparatus of any above claim wherein said sub strate support means comprises a moving belt.

23. The apparatus of any above claim further including current generator means connected to said tip for micro-arc welding when a metallic substrate is used.

24. The apparatus of any above claim further comprising probing means.

25. The apparatus of any above claim wherein said materi al is selected in the group comprising conductors, insulators, semiconductors and superconductors.

26. The apparatus of claim 25 wherein said conductors are selected in the group of low melting point metals and metal alloys, and refractory metals.

27. The apparatus of any above claim wherein said sub strate is selected in the group including semiconduc tors, insulators and metals.

28. The apparatus of any above claim wherein said solid cone-shaped tip is selected in the group including: pointed tips, post shaped tips, needle-shaped tips, brush- like tips and doctor-blade tips.

29. Method for depositing a given material onto a sub strate having a major surface according to a desired pattern comprising the steps of:
providing a substrate (23) having a major surface located in a determined plane;
providing a solid one-shaped tip (11) the external surface of which including its apex is totally wetted by a film (19b) of said material in the molten state contained in a reservoir adjacent to said external surface and capable to nucleate a certain amount thereof;
gently applying the wetted tip against the substrate surface so that the tip apex is maintained above said major surface of the substrate at a determined spacing distance (b) therefrom; and,
selectively providing a relative movement between the tip and the substrate to cause said material to be deposited onto said substrate according the desired pattern (40), the tip moving along directions parallel to the substrate.

30. The method of claim 29 further comprising the step of:
applying a vibratory movement to the tip to improve adherence of the deposited material.

31. The method of any claim 29 or 30 further comprising the step of:
applying micro discharges to the tip.

32. The method of any above claim 29 to 31 wherein said material is selected in the group comprising conduc tors, insulators, semiconductors and superconductors.

33. The method of claim 32 wherein said conductors are selected in the group of low melting point metals and metal alloys, and refractory metals.

34. The method of any claim claim 29 to 33 wherein said substrate is selected in the group including semicon ductors, insulators and metals.

35. The method of any above claim 29 to 34 wherein the tip is made of a refractory metal such as tungsten.

36. Application of the method as recited in any above claim 29 to 35 to the forming of conductive intercon nection lines in a VLSI semiconductor chip.

37. Application of the method as recited in any above claim 29 to 35 to the deposition of an opaque material in the repair of photomasks consisting of an opaque pattern formed onto a glass substrate that are used in the photolithographic steps in the course of semiconductor wafer processing.

38. Application of the method as recited in any above claim 29 to 35 to the deposition of conductive inter connection lines in the customization of VLSI IC chips.

39. Application of the method as recited in any above claim 29 to 35 to the deposition of conductive inter connection lines in the small volume production of VLSI IC chips.

## Patentansprüche

1. Eine Vorrichtung (20) zum direkten Zeichnen eines gewünschten Musters aus einem gegebenen Material auf ein Substrat (23) mit einer Hauptfläche, die umfaßt:
Substrattragemittel (24) zum Tragen des Substrats;
eine feste, konisch zulaufende Spitze (11) aus einem Material, dessen Schmelztemperatur über der Schmelztemperatur des aufzutragenden Materials liegt, wobei die äußere Fläche dieser Spitze von dem Material im geschmolzenen Zustand benetzt werden kann;
Spitzentragemittel (12, 15, 26), die so ausgelegt sind, daß die Schreibspitze (18) über der Hauptfläche des Substrats und in einem vorgegebenen Abstand (h) dazu gehalten wird, während sie in Richtungen parallel zum Substrat geführt wird;
Zufuhrmittel (19a) zum Versorgen der äußeren Fläche der Spitze einschließlich der Schreibspitze mit einer dünnen Schicht (19b) dieses Materials im geschmolzenen Zustand mit Hilfe von Kapillarkräften;
Heizmittel (12) zum Halten der dünnen Schicht etwas über der Schmelztemperatur des betreffenden Materials; und
gesteuerte Antriebsmittel (25, 31) zum Bewirken der relativen Bewegungen zwischen dem Substrat und der Spitze.

2. Die Vorrichtung gemäß Anspruch 1, bei der die Heizmittel gewählt werden aus der Gruppe, die beinhaltet: Elektronenbeschuß, Laserbeschuß, Induktionsheizung und Widerstandsheizung.

3. Die Vorrichtung gemäß Anspruch 2, bei der das Heizmittel ein Widerstandsheizmittel ist.

4. Die Vorrichtung gemäß Anspruch 3, bei der das Spitzentragemittel ein Spitzenhaltemittel (17) umfaßt.

5. Die Vorrichtung gemäß Anspruch 4, bei der das Spitzenhaltemittel im wesentlichen aus einer TO-5 Packungsbasis (15) besteht, die mit zwei Stiften (16, 16') versehen ist.

6. Die Vorrichtung gemäß einem beliebigen obigen Anspruch, bei der das Material, aus dem die Spitze besteht, ein hochschmelzendes Metall ist.

7. Die Vorrichtung gemäß Anspruch 6, bei der das hochschmelzende Metall Wolfram ist.

8. Die Vorrichtung gemäß Anspruch 7, bei der das Widerstandsheizmittel aus einem Heizfaden (12) besteht, der aus einem V-förmigen Wolframdraht gefertigt ist, dessen Spitze an einem Schweißpunkt (13) an das äußerste Ende der Spitze gegenüber der Schreibspitze geschweißt ist, und dessen beide Enden an die Enden (16a, 16'a) der Stifte (16, 16') geschweißt sind, die zwecks Anschluß an eine gesteuerte Energiezufuhr (33) in die Basis eingebettet sind.

9. Die Vorrichtung gemäß Anspruch 7, bei der das Widerstandsheizmittel ein Heizfaden (12) ist, der aus Wolframdraht in Spulenform besteht, dessen zwei Enden an die Enden (16a, 16'a) der Stifte (16, 16') geschweißt sind, und in dem das Ende der Spitze, das der Schreibspitze gegenüber liegt, an eine Wicklung der Spule geschweißt ist, so daß der Schweißpunkt (13) in etwa in der Mitte der Spule gelegen ist.

10. Die Vorrichtung gemäß Anspruch 8 oder 9, bei der die Spitze und die Heizfadenoberfläche in der Nähe des Schweißpunkts die Fähigkeit aufweist, eine gewisse Menge des aufzutragenden Materials zu Kristallisationskeimen zu bilden, wenn sie in das Material im geschmolzenen Zustand eingetaucht wird, wobei diese Menge ihrerseits einen Vorrat (19a) derselben bildet, der die Spitze benetzt, wenn diese letztere auf den Materialschmelzpunkt erwärmt wird.

11. Die Vorrichtung gemäß einem beliebigen obigen Anspruch, bei der die Außenfläche aufgerauht ist.

12. Die Vorrichtung gemäß einem beliebigen obigen Anspruch, in dem das Spitzentragemittel (26) so ausgelegt ist, daß es die Spitze in Z-Richtung in feine Bewegungen versetzt.

13. Die Vorrichtung gemäß Anspruch 12, in dem das Spitzentragemittel ferner eine Piezo-Vorrichtung (29) aufweist, die auf einem Modulblock (30) befestigt ist und einen Arm (28) hat, der an dem Tragemittel (17) befestigt ist.

14. Die Vorrichtung gemäß Anspruch 13, in dem die Piezo-Vorrichtung so ausgelegt ist, daß sie die Spitze in Z-Richtung in feine Bewegungen versetzt.

15. Die Vorrichtung gemäß Anspruch 13 oder 14, in dem die Piezo-Vorrichtung so ausgelegt ist, daß sie die Spitze in Schwingungen versetzt.

16. Die Vorrichtung gemäß einem beliebigen obigen Anspruch, in dem das Spitzentragemittel ferner Mittel beinhaltet, um der Spitze in Z-Richtung in grobe Bewegungen zu versetzen.

17. Die Vorrichtung gemäß Anspruch 16, in dem das Mittel zum Erteilen grober Bewegungen einen Schrittmotor im Modulblock beinhaltet.

18. Die Vorrichtung gemäß einem beliebigen obigen Anspruch, die ferner ein Vakuumkammermittel (21) aufweist, das mit einer Vakuumpumpe (22) verbunden ist, um das Gerät mit eine reinen Atmosphäre zu umgeben.

19. Die Vorrichtung gemäß einem beliebigen obigen Anspruch, die ferner ein Schmelztiegelmittel (35) zur Aufnahme des Materials (34) im geschmolzenen Zustand aufweist.

20. Die Vorrichtung gemäß Anspruch 19, in dem das Schmelztiegelmittel innerhalb der Vakuumkammer eingeschlossen ist.

21. Die Vorrichtung gemäß einem beliebigen obigen Anspruch, in dem das Substrattragemittel eine X-Y-Bühne enthält.

22. Die Vorrichtung gemäß einem beliebigen obigen Anspruch, in dem das Substrattragemittel ein Fließband enthält.

23. Die Vorrichtung gemäß einem beliebigen obigen Anspruch, die ferner an die Spitze angeschlossene Stromgeneratormittel enthält, zwecks Mikrolichtbogenschweißen, wenn ein metallisches Substrat benutzt wird.

24. Die Vorrichtung gemäß einem beliebigen obigen Anspruch, die ferner Sondenmittel enthalten.

25. Die Vorrichtung gemäß einem beliebigen obigen Anspruch, in der das Material ausgewählt wird aus der Gruppe Leiter, Nichtleiter, Halbleiter und Supraleiter.

26. Die Vorrichtung gemäß Anspruch 25, in der die Leiter ausgewählt werden aus der Gruppe niedrigschmelzender Metalle und Legierungen und hochschmelzender Metalle.

27. Die Vorrichtung gemäß einem beliebigen obigen Anspruch, in der das Substrat ausgewählt wird aus der Gruppe Halbleiter, Nichtleiter und Metalle.

28. Die Vorrichtung gemäß einem beliebigen obigen Anspruch, in dem die feste, konisch zulaufende Spitze ausgewählt wird aus der Gruppe spitz zulaufende Spitzen, pfostenförmige Spitzen, nadelförmige Spitzen, bürstenförmige Spitzen und rakelförmige Spitzen.

29. Verfahren zum Abscheiden eines gegebenen Materials auf ein Substrat, das eine Hauptfläche gemäß einem gewünschten Muster aufweist, enthaltend die folgenden Schritte:
Vorsehen eines Substrats (23) mit einer Hauptfläche, die auf einer bestimmten Ebene angeordnet ist;
Vorsehen einer festen, einzeln-ausgeformten Spitze (11), deren Außenfläche, einschließlich ihrer Schreibspitze, vollständig von einer Dünnschicht (19b) des Materials im geschmolzenen Zustand benetzt ist, das in einem Vorrat enthalten ist, der an die Außenfläche anliegt, und in der Lage ist, eine bestimmte Menge desselben zu Kristallisationskeimen zu formen;
vorsichtiges Aufbringen der benetzten Spitze auf die Substratfläche, so daß die Schreibspitze in einem bestimmten Abstand (b) über der Hauptfläche des Substrats gehalten wird; und
selektives Vorsehen einer relativen Bewegung zwischen der Spitze und dem Substrat, damit bewirkt wird, daß das Material gemäß dem gewünschten Muster (40) auf dem Substrat aufgetragen wird, wobei sich die Spitze entlang parallel zum Substrat laufenden Richtungen bewegt.

30. Das Verfahren gemäß Anspruch 29, das ferner den folgenden Schritt enthält:
Aufbringen einer Schwingungsbewegung auf die Spitze, um die Haftung des aufgebrachten Materials zu verstärken.

31. Das Verfahren gemäß Anspruch 29 oder 30, das ferner den folgenden Schritt enthält:
Aufbringen von Mikroentladungen auf die Spitze.

32. Das Verfahren gemäß einem beliebigen der obigen Ansprüche 29 bis 31, in dem das Material ausgewählt wird aus der Gruppe Leiter, Nichtleiter, Halbleiter und Supraleiter.

33. Das Verfahren gemäß Anspruch 32, in dem die Leiter ausgewählt werden aus der Gruppe niedrigschmelzender Metalle und Legierungen und hochschmelzender Metalle.

34. Das Verfahren gemäß einem beliebigen der Ansprüche 29 bis 33, in dem das Substrat ausgewählt wird aus der Gruppe Halbleiter, Nichtleiter und Metalle.

35. Das Verfahren gemäß einem beliebigen der Ansprüche 29 bis 34, in dem die Spitze aus einem hochschmelzenden Metall, wie z.B. Wolfram, gefertigt ist.

36. Anwendung des Verfahrens gemäß einem beliebigen der obigen Ansprüche 29 bis 35 auf das Herstellen von Verbindungsleiterbahnen in einem VLSI-Halbleiterchip.

37. Anwendung des Verfahrens gemäß einem beliebigen der obigen Ansprüche 29 bis 35 auf das Aufbringen eines undurchsichtigen Materials bei der Instandsetzung von Photomasken, bestehend aus einem undurchsichtigen Muster, das auf einem Glassubstrat ausgeformt wird, die für die Photolithographieschritte bei der Halbleiterwaferbearbeitung benutzt werden.

38. Anwendung des Verfahrens gemäß einem beliebigen der obigen Ansprüche 29 bis 35 auf das Aufbringen leitender Verbindungsleiterbahnen bei der kundenspezifischen Fertigung von VLSI-IC-Chips.

39. Anwendung des Verfahrens gemäß einem beliebigen obigen Anspruch 29 bis 35 auf das Aufbringen leitender Verbindungsleiterbahnen bei der Kleinserienfertigung von VLSI-IC-Chips.

## Revendications

1. Un appareil (20) pour l'écriture directe d'un motif souhaité, d'un matériau donné, sur un substrat (23) ayant une surface principale, comprenant :
un moyen support de substrat (24) pour supporter ledit substrat;
un bout massif (11) en forme de cône, constitué d'un matériau réfractaire, dont la température de fusion est supérieure à la température de fusion du matériau à déposer, la surface externe dudit bout étant susceptible d'être mouillée par ledit matériau à l'état fondu;
un moyen support de bout (12, 15, 26), adapté pour maintenir le sommet de bout (18) au-dessus de ladite surface principale du substrat et à une distance d'espacement (h) déterminée de celui-ci; tout en se déplaçant dans des directions parallèles au substrat;
un moyen d'alimentation (19a), pour alimenter ladite surface externe du bout, y compris son sommet, avec un film (19b) dudit matériau se trouvant à l'état fondu, sous l'action des forces capillaires;
un moyen de chauffage (12), pour maintenir ledit fil à une température légèrement supérieure à la température de fusion dudit matériau; et
un moyen d'entraînement commandé (25, 31), pour produire les déplacements relatifs entre ledit substrat et le bout.

2. L'appareil selon la revendication 1, dans lequel ledit moyen de chauffage est choisi dans le groupe comprenant : le bombardement électronique, le bombardement au laser, le chauffage par induction et le chauffage résistif.

3. L'appareil selon la revendication 2, dans lequel le ledit moyen de chauffage est un moyen de chauffage résistif.

4. L'appareil selon la revendication 3, dans lequel ledit moyen de support de bout comprend un moyen de fixation de bout (17).

5. L'appareil selon la revendication 4, dans lequel ledit moyen de fixation de bout est essentiellement constitué d'une base de boîtier TO-5 (15) pourvue de deux broches (16, 16').

6. L'appareil selon l'une quelconque des revendications précédentes, dans lequel le matériau formant ledit bout est un métal réfractaire.

7. L'appareil selon la revendication 6, dans lequel le métal réfractaire est le tungstène.

8. L'appareil selon la revendication 7, dans lequel ledit moyen de chauffage résistif est constitué d'un élément chauffant (12) formé d'un fil en tungstène, en forme de V, dont la partie supérieure est soudée à l'extrémité dudit bout opposé au sommet en un point de soudage (13) et dont les deux autres extrémités sont soudées aux extrémités (16a, 16'a) desdites broches (16, 16') noyées dans ladite base, pour établir une connexion vis-à-vis d'une alimentation de puissance commandée (33).

9. L'appareil selon la revendication 7, dans lequel ledit moyen de chauffage résistif est constitué d'un élément chauffant, formé d'une bobine en fil de tungstène, dont les deux extrémités sont soudées aux extrémités (16a, 16'a) desdites broches (16, 16') et dans lequel l'extrémité du bout placé à l'opposé du sommet est soudée à une spire de ladite bobine, de manière que le point de soudage (13) soit situé à peu près au milieu de ladite bobine.

10. L'appareil selon la revendication 8 ou 9, dans lequel le bout et la surface de l'élément chauffant, à proximité dudit point de soudage, a la possibilité de nucléer une certaine quantité du matériau à déposer lorsqu'il est plongé dans ce matériau placé à l'état liquide, ladite quantité, à son tour, formant un réservoir (19a) de celle-ci, qui mouille le bout, lorsque ce dernier est chauffé à la température du point de fusion du matériau.

11. L'appareil selon la revendication 10, dans lequel ladite surface extérieure est rendue rugueuse.

12. L'appareil selon l'une quelconque des revendications précédentes, dans lequel ledit moyen support de bout (26) est adapté pour produire des déplacements fins du bout dans la direction Z.

13. L'appareil selon la revendication 12, dans lequel ledit moyen support de bout comprend en outre un piézo-dispositif (29) fixé à un bloc modulaire (30) et ayant un bras (28) attaché audit moyen de fixation (17).

14. L'appareil selon la revendication 13, dans lequel ledit piézo-dispositif est adapté pour produire un déplacement fin du bout dans la direction Z.

15. L'appareil selon la revendication 13 ou 14, dans lequel ledit piézo-dispositif est adapté pour produire des vibrations sur le bout.

16. L'appareil selon l'une quelconque des revendications précédentes, dans lequel ledit moyen support de bout comprend en outre un moyen pour produire un déplacement grossier dans la direction Z du bout.

17. L'appareil selon la revendication 16, dans lequel ledit moyen pour produire un déplacement grossier comprend un moteur pas-à-pas monté dans le bloc modulaire.

18. L'appareil selon l'une quelconque des revendications précédentes, comprenant en outre un moyen à chambre à vide (21), relié à une pompe à vide (22) afin d'enclore ledit appareil dans une atmosphère propre.

19. L'appareil selon l'une quelconque des revendications précédentes, comprenant en outre un moyen formant creuset (35) destiné à contenir ledit matériau (34) à l'état fondu.

20. L'appareil selon la revendication 19, dans lequel ledit moyen formant creuset est enclos à l'intérieur de ladite chambre.

21. L'appareil selon l'une quelconque des revendications précédentes, dans lequel ledit moyen support de substrat comprend un plateau X-Y.

22. L'appareil selon l'une quelconque des revendications précédentes, dans lequel ledit moyen support de substrat comprend une courroie mobile.

23. L'appareil selon l'une quelconque des revendications précédentes, comprenant en outre un moyen générateur de courant, connecté audit bout, pour produire un soudage par micro-arc lorsqu'on utilise un substrat métallique.

24. L'appareil selon l'une quelconque des revendications précédentes, comprenant en outre un moyen de sondage.

25. L'appareil selon l'une quelconque des revendications dans le groupe comprenant des matériaux conducteurs, isolants, semi-conducteurs et supraconducteurs.

26. L'appareil selon la revendication 19, dans lequel lesdits conducteurs sont choisis dans le groupe des métaux et alliages métalliques à bas point de fusion, et des métaux réfractaires.

27. L'appareil selon l'une quelconque des revendications précédentes, dans lequel ledit substrat est choisi dans le groupe comprenant les semi-conducteurs, les isolants et les métaux.

28. L'appareil selon l'une quelconque des revendications précédentes, dans lequel ledit bout massif à forme de cône est choisi dans le groupe comprenant : les bouts pointus, les bouts en forme de poteaux, les bouts en forme d'aiguille, les bouts du genre soies et les bouts en raclette.

29. Procédé pour déposer un matériau donné, sur un substrat ayant une surface principale, selon un motif souhaité, comprenant mes étapes consistant à :
fournir un substrat (23) ayant une surface principale située dans un plan déterminé;
fournir un bout (11) massif monopièce, dont la surface externe, y compris son sommet, est totalement mouillée par un film (19b) dudit matériau placé à l'état fondu, contenu dans un réservoir adjacent à ladite surface externe et dont une certaine quantité est susceptible de nucléer;
appliquer doucement le bout mouillé contre la surface du substrat, de manière que le sommet du bout soit maintenu au-dessus de ladite surface principale du substrat, à une distance d'espacement (b) déterminée de celui-ci; et
produire sélectivement un déplacement relatif, entre le bout et le substrat, pour provoquer le dépôt dudit matériau sur ledit substrat, selon le motif souhaité (40), le bout se déplaçant suivant des directions parallèles au substrat.

30. Le procédé selon la revendication 29, comprenant en outre l'étape consistant à :
appliquer un mouvement vibrant sur le bout, afin d'améliorer l'adhérence du matériau déposé.

31. Le procédé selon la revendication 29 ou 30, comprenant en outre l'étape consistant à :
appliquer des micro-décharges sur le bout.

32. Le procédé selon l'une quelconque des revendications 29 à 31, dans lequel ledit matériau est choisi dans le groupe comprenant les conducteurs, isolants, semi-conducteurs et supraconducteurs.

33. Le procédé selon la revendication 32, dans lequel lesdits conducteurs sont choisis dans le groupe des métaux et alliages métalliques à bas point de fusion, et des métaux réfractaires.:

34. Le procédé selon l'une quelconque des revendications 29 à 33, dans lequel ledit substrat est choisi dans le groupe comprenant les semi-conducteurs, les isolants et les métaux.

35. Le procédé selon l'une quelconque des revendications 29 à 34, dans lequel le bout est constitué d'un métal réfractaire tel que le tungstène.

36. Application du procédé selon l'une quelconque des revendications 29 à 35, à la formation de lignes d'interconnexion conductrices dans une puce électronique à semiconducteur VLSI.

37. Application du procédé selon l'une quelconque des revendications 29 à 35, à la déposition d'un matériau opaque dans la réparation de photomasques constitués d'un motif opaque formé sur un substrat en verre, tels qu'utilisés aux étapes photolithographiques au cours du traitement d'une plaquette à semiconducteur.

38. Application du procédé selon l'une quelconque des revendications 29 à 35, à la déposition de lignes d'interconnexion conductrices dans la particularisation de puces électroniques à circuits intégrés VLSI.

39. Application du procédé selon l'une quelconque des revendications 29 à 35, à la déposition de lignes d'interconnexion conductrices dans une production en petite série de puces électroniques à circuits intégrés VLSI.
